# FASCICULE DE BREVET EUROPEEN

(11) **EP 2 129 542 B1**
(45) Date de publication et mention de la délivrance du brevet: **28.01.2015**
(21) Numéro de dépôt: 08761842.7
(22) Date de dépôt: 05.02.2008
(51) Int. Cl.: B60L 9/30, B60L 3/00

(54) **EQUIPEMENT ELECTRIQUE DISPOSE EN TOITURE D'UN VEHICULE FERROVIAIRE A TRACTION ELECTRIQUE**
AUF DEM DACH EINES ELEKTRISCHEN SCHIENENZUGFAHRZEUGS ANGEORDNETE ELEKTRISCHE AUSRÜSTUNG
ELECTRIC EQUIPMENT ARRANGED ON THE ROOF OF AN ELECTRIC TRACTION RAILWAY VEHICLE

(30) Priorité: 20.02.2007 FR 0701206
(43) Date de publication de la demande: 09.12.2009
(73) Titulaire: ALSTOM Transport Technologies, 92300 Levallois-Perret (FR)
(72) Inventeur: AUBIGNY, Christophe, 65390 Sarniguet (FR); QUENTIN, Nicolas, 65420 Ibos (FR)
(74) Mandataire: Holubec, Méhdi
(86) Numéro de dépôt international: PCT/FR2008/000139
(87) Numéro de publication internationale: WO 2008/113903

(56) Documents cités:
- EP-A- 1 245 432
- EP-A1- 0 594 457
- JP-A- 6 054 401
- JP-A- 8 251 701
- US-A1- 2004 216 636

## Description

La présente invention concerne un équipement électrique disposé en toiture d' un véhicule ferroviaire à traction électrique, le dit véhicule étant équipé d'au moins un pantographe et d'une ligne de toiture véhiculant le courant capté depuis une ligne caténaire, à partir de la connexion audit pantographe , vers des dispositifs électriques de traction du véhicule, ledit équipement électrique comprenant au moins un appareil de protection desdits dispositifs électriques de traction et étant disposé sur un support mécanique.

Un véhicule ferroviaire comporte en toiture de nombreux équipements. On peut ainsi trouver des pantographes monophasés et respectivement continu destinés à véhiculer le courant depuis une ligne caténaire alimenté par un courant continu et respectivement monophasé, vers une ligne de toiture alimentant le véhicule en énergie électrique. On peut également trouver des équipements électriques haute tension par exemple un commutateur monophasé / continu, un sectionneur de mise à la terre, un ou des appareils de disjonction et des équipements complémentaires du type rhéostat de freinage ou dispositif de climatisation.

Du fait de la disposition d'un nombre important d'équipements en toiture, la toiture du véhicule ferroviaire est particulièrement encombrée. Ceci limite la place disponible en toiture pour chacun des équipements déjà présents en toiture ainsi que la place disponible en toiture pour ajouter de nouveaux équipements réalisant des fonctions nouvelles.

Or, il résulte de nouvelles réglementations imposant une liberté d'exercice pour plusieurs opérateurs fournisseurs d'électricité sur un réseau et pour plusieurs opérateurs utilisateurs de cette énergie sur le même réseau, un besoin récent de mesure de l'énergie électrique consommée par un train et notamment prélevée à la caténaire.

Cette mesure de l'énergie électrique fournie à un train permet de réaliser la facturation aux consommateurs par le fournisseur.

La réalisation de cette mesure est dans son principe extrêmement simple : il faut relever l'intensité du courant consommé, sa tension et le temps de consommation, soit en continu soit par échantillonnage à une fréquence significative, pour prendre en compte les variations de ces deux paramètres au fil du temps.

En pratique, les choses sont plus compliquées par le fait que les appareils de mesure sont dans un environnement de réseau haute tension (de 750 volts en courant continu à 25000 volts en courant alternatif selon les parties de réseau parcouru) pour ce qui concerne l'acquisition de la variable et dans un environnement basse tension pour ce qui concerne l'élaboration et le traitement du signal. L'isolation entre les deux environnements, appelé isolement galvanique, requiert donc un soin et un sérieux particuliers.

Les moyens connus pour assurer cette isolation galvanique sont par exemple, mis en oeuvre au niveau des transformateurs que les appareils de mesure comportent, l'isolation requise demandant de mettre en oeuvre entre primaire et secondaire de tels transformateurs des matériaux diélectriques de haute qualité et surtout dans un volume suffisant pour éloigner au maximum les pièces conductrices les unes des autres.

On connaît du document US2004/216636 un équipement électrique disposé en toiture d'un véhicule ferroviaire à traction électrique, ledit véhicule étant équipé d'un pantographe et d'une ligne de toiture véhiculant le courant capté depuis une ligne caténaire, à partir de la connexion audit pantographe, vers des dispositifs électriques de traction du véhicule, ledit équipement électrique comprenant des moyens de mesure de l'intensité du courant transmis depuis la caténaire vers la ligne de toiture.

De plus, cette mesure de l'énergie fournie au véhicule doit être réalisée avec une précision maximale afin de limiter les risques d'erreurs pour la facturation de l'énergie consommée par les exploitants. Cette mesure doit être effectuée au plus près de la source d'alimentation de la ligne de toiture. Il est donc indispensable de disposer les équipements permettant de réaliser cette fonction en toiture.

Un des buts de l'invention est donc de proposer un équipement électrique destiné à être disposé en toiture d'un véhicule ferroviaire qui soit suffisamment compact pour pouvoir être logé parmi le matériel de toiture du véhicule ferroviaire à traction électrique.

Un autre but de l'invention est de disposer en toiture un équipement électrique qui participe au moins en partie à la mesure de l'énergie fournie au véhicule ferroviaire par la ligne caténaire et qui autorise la mesure de l'énergie fournie au véhicule ferroviaire de traction électrique avec une bonne précision.

Un autre but de l'invention est de disposer en toiture un équipement électrique qui participe au moins en partie à la détection du type de tension fournie au véhicule ferroviaire par la ligne caténaire.

Un autre but de l'invention est de disposer en toiture un équipement électrique qui participe au moins en partie à la détection des défauts de courant et d'harmonique du courant qui autorise la protection de l'engin.

A cet effet, l'invention porte donc sur un équipement électrique disposé en toiture d' un véhicule ferroviaire à traction électrique, selon la revendication 1

Un tel équipement de toiture présente l'avantage de former un équipement de protection qui permet à la fois de détecter les défauts de sur-courant dans le circuit d'alimentation du véhicule et de protéger les équipements de traction au moyen du disjoncteur lorsqu'un défaut de sur-courant est détecté. Un tel dispositif présente une bonne sécurité de fonctionnement car le nombre de jonctions entre le moyen de détection du courant et le disjoncteur est limité.

Un tel équipement présente en outre l'avantage d'être autonome, vis à vis d'équipements extérieurs, quant à son déclenchement ou son activation.

Selon d'autres modes de réalisation, l'équipement électrique possède une ou plusieurs des caractéristiques suivantes, prise(s) isolément ou selon toutes les combinaisons techniquement possibles :
- le dispositif de mesure comprend des moyens de mesure de la tension sur le support mécanique ;

Un tel équipement présente l'avantage de permettre de limiter l'usure du disjoncteur. Il rend possible l'asservissement, la fermeture et de l'ouverture du disjoncteur à une valeur de tension prédéfinie (minimum, maximum).
- lesdits moyens de mesure de la tension et de l'intensité sont logés au sein d'un unique isolateur ;
- le dispositif de mesure comprend un environnement haute tension étant confiné dans le premier évidement ménagé dans l'isolateur et un environnement basse tension étant confiné dans un second évidement dudit isolateur ;

- on dispose sur le support mécanique au moins un des équipements de protection pris parmi :
   - un sectionneur de mise à la terre,
   - un dispositif de protection contre les surtensions,
   - un disjoncteur alternatif ;
- il comprend les raccordement électriques entre les équipements disposés sur le support ;
- le dispositif de mesure est connecté, d'une part directement au pantographe par l'intermédiaire d'une unique connexion et d'autre part au disjoncteur par l'intermédiaire d'une unique connexion ;
- le dispositif de mesure mesure le courant au point chaud.
- le disjoncteur est un disjoncteur monophasé.

D'autres caractéristiques et avantages de l'invention ressortiront de la description donnée ci-après d'un exemple de sa réalisation.

Il sera fait référence aux dessins annexés parmi lesquels :
- la figure 1 est un schéma électrique de captage du courant pour un véhicule ferroviaire selon un premier mode de réalisation du premier aspect de l'invention
- La figure 2 est un schéma électrique d'un dispositif de mesure selon un premier mode de réalisation de l'invention
- la figure 3 est un schéma d'implantation de ce dispositif de mesure dans un isolateur de la ligne de toiture haute tension de l'engin ferroviaire consommateur de l'énergie mesurée.
- La figure 4 illustre un équipement électrique selon un mode de réalisation possible de l'invention représenté en perspective.
- la figure 5 est une variante du schéma électrique de captage du courant pour un véhicule ferroviaire selon un second mode de réalisation du premier aspect de l'invention

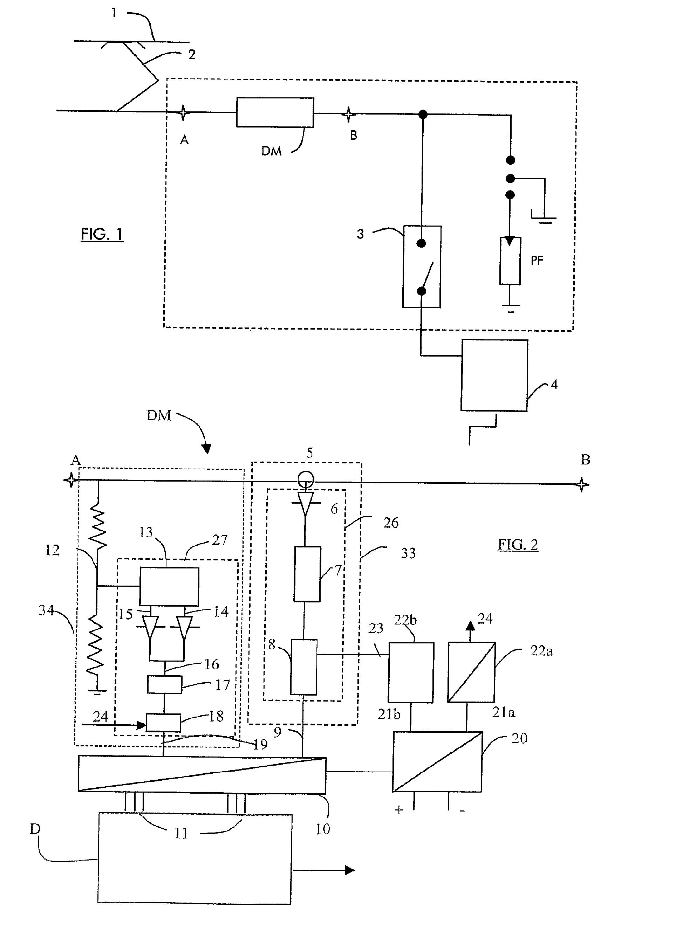

A la figure 1, on a représenté la ligne caténaire et le pantographe 2 du véhicule, le pantographe 2 est représenté dans sa position dépliée pour venir en contact de ladite caténaire 1 afin d'établir la connexion entre la ligne caténaire 1 et la ligne de toiture haute tension du véhicule ferroviaire notée L. La ligne caténaire 1 est susceptible d'être alimentée en courant continu ou bien monophasé. La ligne de toiture L véhicule le courant capté par le pantographe 2 sur la ligne caténaire 1 en passant par le dispositif de mesure noté DM pour parvenir à un appareil de disjonction 3, ou disjoncteur, qui est connecté aux dispositifs électriques de traction 4 du véhicule. L'appareil de disjonction 3 est adapté pour protéger les équipements de traction du véhicule en présence d'un défaut ou d'un surcourant dans le circuit d'alimentation du véhicule. Outre l'appareil de disjonction 3 et le dispositif de mesure DM, l'équipement électrique EE selon un premier mode de réalisation de l'invention, représenté par des traits pointillés sur la figure 1 comporte différents équipements électrotechniques disposés en toiture du véhicule ferroviaire et mentionnés ci-après.

Un sectionneur 36 de mise à la terre 37 ainsi qu'un dispositif de protection 38 contre les surtensions.

Le sectionneur 36 de mise à la terre est adapté pour pouvoir être basculé manuellement, électriquement ou bien pneumatiquement entre un premier état dit de « service » dans lequel il n'est relié électriquement à aucun composant, et un second état dans lequel il relie l'amont et l'aval de l'appareil de disjonction 3 au circuit de terre 37. Le dispositif de protection 38 contre les surtensions est adapté pour pouvoir basculer automatiquement entre un premier état dans lequel il se comporte comme un interrupteur fermé et un second état dans lequel il se comporte comme un interrupteur ouvert, lorsque la tension entre ses deux bornes dépasse un seuil prédéfini.

Sur la figure 2, on a représenté le dispositif de mesure DM positionné entre les points A et B de la ligne de toiture L.

Sur la figure 5, on a représenté le dispositif de mesure DM positionné entre les points A et B de la ligne de toiture L.

Tel que représenté sur les figures 2 et 5, sur cette ligne L, et de manière tout à fait connue, un capteur d'intensité 5, par exemple un shunt de mesure de courant, ou bien un transformateur d'intensité, ou bien un capteur d'intensité à effet hall un dispositif 6 permettant de donner une image analogique calibré du courant mesuré, par exemple un amplificateur de mise en forme du signal, émet un signal analogique converti en un signal numérique par un convertisseur 7 dont la sortie aboutit à un convertisseur électrique/optique 8 transformant le signal électrique numérique issu du convertisseur en un signal optique véhiculé par une fibre optique 9 en direction d'un convertisseur optique/électrique 10 possédant des sorties 11 destinées au raccordement de l'électronique d'exploitation de ce signal issu du capteur d'intensité et représentatif de l'intensité du courant d'alimentation de la ligne L haute tension de l'engin.

Par un diviseur de tension 12, il est possible de recueillir au moyen d'un discriminateur 13 de tensions continue ou alternative, des signaux représentatifs de ces tensions. Par exemple, le signal présent à la sortie 14 du discriminateur 13 est significatif de la valeur de la tension alternative sur la ligne haute tension L.

La sortie 15 est réservée à un signal significatif d'une tension continue sur la ligne haute tension L.

L'un ou l'autre de ces signaux est conduit à l'entrée 16 d'un convertisseur 17 analogique numérique dont la sortie aboutit à l'entrée d'un convertisseur 18 électrique/optique. Le signal optique engendré par ce convertisseur est conduit par une fibre optique 19 à l'entrée du convertisseur 10 qui présentera en réponse sur certaines de ses sorties 11 un signal électrique destiné à être exploité par le dispositif en combinaison avec le signal électrique représentatif de la valeur de l'intensité du courant d'alimentation.

Par un capteur de courant 5, il est possible de recueillir au moyen d'un discriminateur de courant, de manière analogue à la discrimination de la tension 13, le courant continue ou alternatif, des signaux représentatifs de ces courants.

Le signal électrique représentatif de la valeur de l'intensité du courant d'alimentation ainsi que le signal représentatif de la tension présente sur la ligne haute tension L, tous deux disponibles sur certaines sorties 11 du convertisseur 10 peuvent être transmis à un calculateur ou moyen de calcul de l'énergie, non représenté, pour calculer l'énergie fournie par la caténaire au véhicule ferroviaire à partir du signal représentatif de la valeur de l'intensité du courant d'alimentation de la caténaire et respectivement du signal représentatif de la tension présente sur la ligne haute tension L.

Le signal électrique représentatif de la valeur de l'intensité du courant d'alimentation ainsi que le signal représentatif de la tension présente sur la ligne haute tension L, tous deux disponibles sur certaines sorties 11 du convertisseur 10 peuvent être transmis à un calculateur ou moyen de détection D, pour détecter les défauts de courant ou bien de tension fournie par la caténaire au véhicule ferroviaire à partir du signal représentatif de la valeur de l'intensité du courant d'alimentation de la caténaire et respectivement du signal représentatif de la tension présente sur la ligne haute tension L.

Certains des composants du dispositif ont besoin pour fonctionner d'une alimentation en énergie électrique, notamment les convertisseurs électriques/optiques ou optiques/électriques tels que ceux 10, 8 et 18. Pour ce qui concerne le convertisseur 10, celui-ci est alimenté directement par une batterie qui elle-même est connectée à un convertisseur 20 d'énergie électrique continue en une énergie optique, sous la forme d'un faisceau optique émis par un système lumineux tel qu'une diode. Le faisceau optique est conduit par des fibres optiques 21a, 21 b en direction de convertisseurs optique/électrique 22a, 22b qui possèdent respectivement une sortie 24 d'alimentation du convertisseur électrique/optique 18 et une sortie 23 d'alimentation du convertisseur électrique/optique 8.

De façon avantageuse, l'ensemble des éléments précités sont disposés dans l'isolateur 25.

Dans une variante, les signaux représentatifs de l'intensité et/ou de la tension, disponibles des sorties 11 du convertisseur 20 sont transmis à un ou plusieurs calculateurs, non représentés, pour détecter les surcharge en courant sur la ligne de toiture L ou pour détecter les surtensions sur cette même ligne ou bien détecter les harmoniques du courant. Les calculateurs transmettent ainsi des ordres à des actionneurs, non représentés, pour activer les systèmes de protection des dispositifs électriques de traction du véhicule.

Par exemple, lorsqu'un calculateur détecte une sur-intensité sur la ligne de toiture, il commande l'ouverture de l'appareil de disjonction 3 pour protéger les dispositifs électriques de traction du véhicule contre une sur-intensité. Ce ou ces calculateurs pourront être localisés dans l'enveloppe de l'équipement électrique EE faisant l'objet de l'invention, c'est à dire sur le support 40.

Le calculateur permettant l'activation du disjoncteur est, par exemple, logé dans l'enceinte du dispositif de mesure DM.

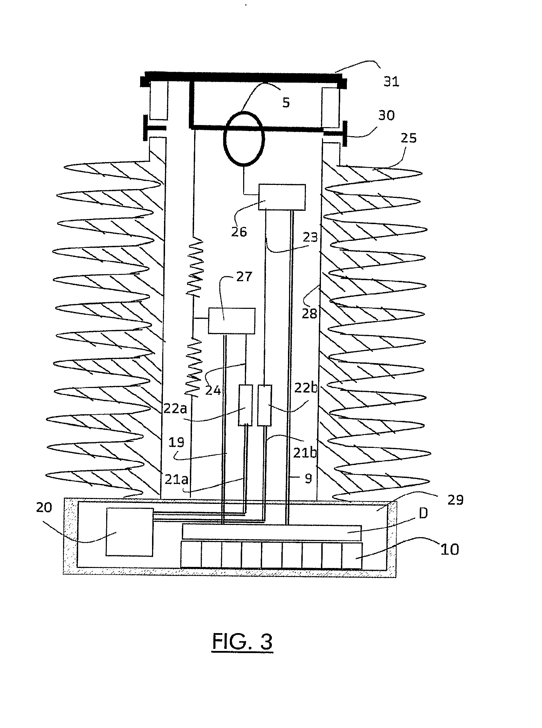

La figure 3 illustre la mise en place du circuit représenté à la figure 1 à l'intérieur d'un corps isolateur 25 et montre ainsi comment une parfaite isolation galvanique est assurée dans le dispositif de mesure selon l'invention. Sur cette figure on retrouve la plupart des éléments déjà décrits avec les mêmes références. Les éléments relatifs au traitement du signal du capteur d'intensité 5 sont regroupés schématiquement dans un bloc 26 alimenté en basse tension par la ligne 23 et présentant en sortie sur une fibre optique 9 le signal optique représentatif de l'intensité mesurée.

Ainsi, les moyens de mesure de l'intensité 33, comprennent un capteur d'intensité 5 et des éléments relatifs du signal du capteur d'intensité, regroupés schématiquement dans le bloc 26.

De la même manière, les moyens de traitement du signal de tension issus du diviseur 12 sont regroupés dans un bloc 27 auquel aboutit la ligne d'alimentation 24 et de laquelle est issue la fibre optique 19.

Ainsi, les moyens de mesure de la tension d'alimentation du train comprennent un pont diviseur de tension 12 et des moyens du traitement du signal de la tension issus du diviseur 12 et regroupés dans le bloc 27.

On comprend donc au vu de cette figure que l'environnement haute tension est confiné dans un espace supérieur 28 ménagé dans l'isolateur 25, traversé par la ligne L de toiture de l'engin ferroviaire tandis que l'environnement basse tension est confiné dans un évidement 29 inférieur de cet isolateur. Entre les deux évidements, seules des fibres optiques forment la liaison des différents composants du dispositif de l'invention.

Ainsi, on réalise un isolement galvanique extrêmement important entre l'étage haute tension des appareils de mesure et l'étage basse tension de ces derniers. La conversion d'une énergie électrique en énergie optique et la conversion inverse est réalisée au moyen d'appareils connus de petit encombrement qui permettent donc de loger le dispositif de mesure sous un faible volume et en particulier de regrouper dans un unique isolateur 25 des moyens de mesure de la tension 34 et des moyens de mesure de l'intensité 33.

Dans une variante, le dispositif de mesure noté DM ne comprend que les moyens de mesure de l'intensité 33 du courant d'alimentation haute tension du véhicule ferroviaire. Plus précisément, le dispositif de mesure DM est un dispositif de mesure de l'intensité du courant d'alimentation haute tension du véhicule ferroviaire, regroupant dans un même isolateur les moyens de mesure de l'intensité 33 du courant et éventuellement le convertisseur 10 optique électrique et / ou les équipements d'alimentation basse tension (20, 22b) des moyens de mesures du courant nécessaires à leur fonctionnement.

Dans cette variante, le dispositif de mesure DM présente l'avantage de disposer de la mesure du courant pour les engins existant dont on souhaite rajouter la mesure de l'énergie tout en utilisant le mesure de la tension qui préexiste sur la ligne de toiture L.

Le dispositif de mesure selon l'invention, et plus particulièrement les moyens 34 de mesure de la tension, peuvent également être utilisés comme moyen de reconnaissance du réseau (de la tension du courant délivré à l'engin de traction) qui peut-être de 750 volts en courant continu, 1500 volts en courant continu, de 3000 volts en courant continu (généralement traité comme le précédent), de 15000 volts en courant alternatif à 16 Hz 1/3, de 25000 volts en courant alternatif à 50 Hz ou à 60 Hz, de 12.000 volts alternatif à 60 Hz et de 12.000 volts alternatif à 25 Hz pour ne citer que les cas de figures rencontrés dans les principaux pays industrialisés. En effet, le signal optique présent à la sortie de la fibre 19 est significatif d'une tension de mesure dont la valeur est elle-même en correspondance avec la tension du courant du réseau. Ainsi chacune des trois sorties 11 affectées à la tension peut, par un jeu de relais dans les moyens de conversion 10, être attribuée l'une des tensions que peut offrir le réseau. La présence du signal sur une seule des trois sorties 11 affectées à la tension permet de reconnaître la tension du réseau en train d'être parcouru par l'engin ferroviaire.

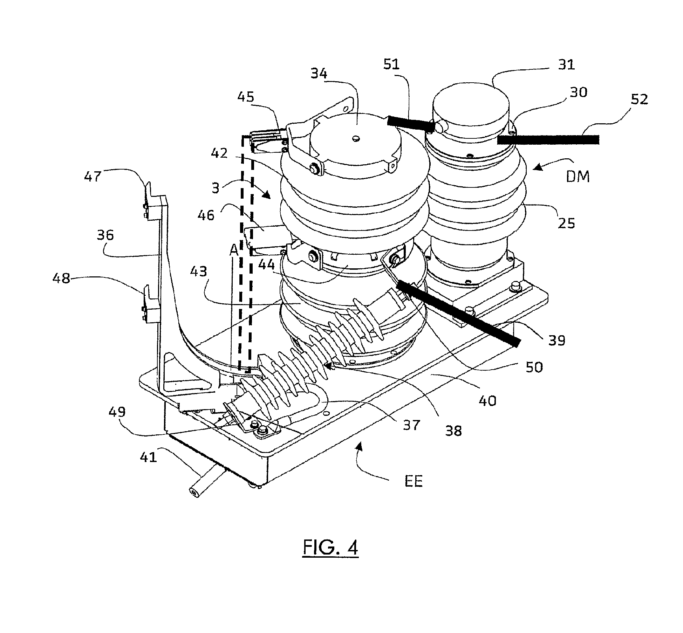

La figure 4 illustre un exemple de disposition des appareils compris dans l'équipement électrique EE selon l'invention représenté en pointillés sur la figure 1.

Les appareils compris dans l'équipement électrique EE sont disposés sur un unique support 40 en aluminium. Les appareils fixés et connectés électriquement à cette plaque sont automatiquement reliés à la terre au travers de la fixation de la plaque support 40 sur le véhicule et individuellement par la fixation de ces appareils sur cette même plaque. L'équipement électrique EE comprend donc, disposés sur un même support mécanique, les équipements listés ci-après : des dispositifs de protection des dispositifs électriques de traction et du personnel de maintenance: un sectionneur 36 de mise à la terre 37, un dispositif de protection 38 contre les surtensions, un appareil de disjonction 3 ainsi qu'un dispositif de mesure DM tel que représenté sur la figure 3. Dans ce mode de réalisation, les moyens de mesure de l'intensité 33 et les moyens de mesure de la tension 34 sont disposés au sein de l'isolateur 25.

Une liaison cuivrique 52, fixée à une bride 30 disposée en partie intermédiaire de l'isolateur 25 dans lequel est confiné le dispositif de mesure DM, relie électriquement le dispositif de mesure DM au pied du pantographe 2.

Une liaison cuivrique 51 sous forme d'un câble de cuivre établit une connexion électrique entre le disjoncteur 3 et le dispositif de mesure DM en étant fixé par l'intermédiaire d'une de ses deux extrémités, à une bride 34 disposée en partie haute du disjoncteur 3 et par sa seconde extrémité à une bride 31 disposée en partie haute du dispositif de mesure DM.

Le corps du disjoncteur 3 comprend deux isolateurs 42, et 43 respectivement en partie basse et en partie haute, renfermant chacun, des éléments électromécaniques. Lesdits isolateurs sont séparés par une bride 44 supportant une pince 46. La bride 35 reçoit également une pince 45.

La bride 44 reçoit également une liaison cuivrique 39 non représentée entièrement, sous forme d'une barre de cuivre, qui établit la liaison électrique entre le disjoncteur 3 et les dispositifs électriques de traction 4 du véhicule ferroviaire, non représentés sur la figure 4.

Le support 40 reçoit également un dispositif de protection 38 contre les surtensions.

Une des deux extrémités 49 dudit dispositif de protection 38 est reliée électriquement à la masse en étant fixée au support 40 et la seconde extrémité 50 dudit dispositif de protection 38 est connectée électriquement au disjoncteur en étant reliée à la bride 44.

Le sectionneur de mise à la terre 36, comprend une barre de cuivre fixée au support 40 à laquelle sont fixés deux couteaux 47 et 48 de cuivre. Les couteaux 47 et 48 sont respectivement aptes à être reçus par des pinces 45 et 46 fixées respectivement aux brides 34 et 44 du disjoncteur 3 afin d'établir la liaison électrique entre le disjoncteur 3 et le sectionneur de mise à la terre 36. Cette liaison est établie lorsque le sectionneur de mise à la terre est dans la position représentée en traits pointillés sur la figure 4.

Le sectionneur de mise à la terre 36 est apte à être déplacé manuellement, électriquement ou bien pneumatiquement au moyen d'une tige d'actionnement 41 qui est adaptée pour faire pivoter le sectionneur de mise à la terre 36 un mouvement de rotation autour de l'axe A sensiblement vertical à la surface supérieure du support 40 et passant par le point de fixation du sectionneur de mise à la terre 36 au support 40.

Le sectionneur 36 est apte à pivoter entre une première position, telle que représentée en trait plein sur la figure 4, dans laquelle il est en contact avec la liaison 37 de mise à la masse et dans laquelle les couteaux sont libres, et une seconde position, représentée en traits pointillés sur la figure 4, dans laquelle les couteaux 47 et 48 sont respectivement reçus par les pinces 45 et 46 et dans laquelle le sectionneur de mise à la masse établit la liaison entre le disjoncteur 3 et la masse du train. Le disjoncteur 3 est un disjoncteur monophasé.

Dans le mode de réalisation particulièrement avantageux de l'invention, illustré sur la figure 4, on fixe, sur un même support mécanique plusieurs dispositifs électrotechniques réalisant plusieurs fonctionnalités différentes devant être assurées par un système de captage de courant pour un matériel ferroviaire.

Cet équipement présente donc de manière compacte, sur un unique support plusieurs fonctionnalités différentes, il est donc peu encombrant et présente un nombre de pièces constitutives limité, il peut donc être facilement intégré en toiture.

Cet équipement présente également l'avantage de ne disposer que de deux connexions de puissance électrique avec les équipements extérieurs (pantographe 2, dispositifs électriques de traction 4). Cette configuration permet de limiter le nombre et la longueur des connexions électriques externes à effectuer entre les différents équipements en toiture et donc de limiter l'encombrement en toiture.

La présence sur le support 40 du dispositif de mesure DM comprenant des moyens de mesure du courant 34 permet de proposer un dispositif électrique réalisant une nouvelle fonctionnalité de mesure de courant par rapport aux dispositifs existants.

La disposition sur un unique support d'appareillages de protection tels qu' un disjoncteur 3, un sectionneur 36 de mise à la terre , un dispositif de protection 38 contre les surtensions, et d'un dispositif de mesure DM logeant dans un unique isolateur des moyens de mesure de l'intensité 33 du courant ainsi que des moyens de mesure de la tension 34 permet de proposer un dispositif intégrant un fonctionnalité supplémentaire par rapport aux dispositifs existants étant dépourvus de moyens de mesure du courant 33 tout en limitant l'espace supplémentaire nécessaire à la mesure du courant. Ainsi il est possible de réaliser une fonction supplémentaire de mesure d'énergie dans un espace identique à celui occupé pour la réalisation des fonctions de disjonction, de mise à la terre et de protection de surtensions, en ajoutant sur un support, comportant initialement prévu pour ces fonctions, un dispositif de mesure DM.

La mesure du courant permet également de réaliser des fonctions de protection nécessitant la connaissance de la valeur du courant en envoyant le signal représentatif de l'intensité disponible sur la ligne de toiture L à un calculateur qui commande des actionneurs pour activer le dispositif de protection, disposé sur le support mécanique 40. Le calculateur pourra faire partie intégrante de l'équipement électrique EE disposé en toiture.

Dans un autre mode de réalisation non représenté, l'équipement électrique EE comprend un unique dispositif de protection, un dispositif de disjonction 3 et un dispositif de mesure DM comprenant au moins un moyen de mesure parmi un moyen de mesure de l'intensité 33 ou un moyen de mesure de la tension 34.

La connexion du pantographe 2, directement au dispositif de mesure DM permet de réaliser la mesure de l'intensité du courant sur la ligne de toiture L, au plus près du pantographe. Cette disposition présente l'avantage de limiter les pertes dans les connexions électriques et / ou dans des équipements électriques qui pourraient être interposés entre le pantographe et le dispositif de mesure DM. On dit que l'on mesure l'intensité au « point chaud ». Cette configuration permet, la mesure de l'intensité du courant et donc l'énergie transmis par la caténaire à la ligne de toiture avec la meilleure précision possible.

Dans une variante dans laquelle on loge les moyens de mesure de l'intensité 33 du courant et les moyens de mesure de la tension 34 dans deux isolateurs différents, on dispose les moyens de mesure de l'intensité 33 du courant, sur un unique support 40 avec au moins un des équipements électriques de protection pris parmi disjoncteur 3, un sectionneur 36 de mise à la terre , un dispositif de protection 38 contre les surtensions.

Cette configuration est avantageuse si la mesure de la tension est effectuée ailleurs sur le circuit de captage du courant et que seule la mesure de l'intensité du courant transmis par la caténaire à la ligne de toitures est nécessaire.

Dans une variante dans laquelle on loge les moyens de mesure de l'intensité 33 du courant et les moyens de mesure de la tension 34 dans deux isolateurs indépendants, on dispose sur un unique support 40, les deux isolateurs logeant les moyens de mesure de l'intensité 33 du courant et les moyens de mesure de la tension 34 avec au moins un des équipements électriques de protection pris parmi disjoncteur 3, un sectionneur 36 de mise à la terre, un dispositif de protection 38 contre les surtensions. Cette configuration permet de modifier les connexions électriques entre les moyens de mesure de la tension 34, les moyens de mesure du courant 33 et les autres équipements électriques disposés sur la plaque ainsi qu'avec le pantographe 2 et les dispositifs électriques de traction 4. Ainsi on peut effectuer la mesure de la tension et la mesure du courant en deux endroits différents du circuit de captage du courant tout en conservant les moyens de mesure du courant 33 et de la tension 34 sur un unique support mécanique.

## Revendications

1. Equipement électrique (EE) disposé en toiture d'un véhicule ferroviaire à traction électrique, ledit véhicule étant équipé d'au moins un pantographe (2) et d'une ligne de toiture (L) véhiculant le courant capté depuis une ligne caténaire (1), à partir de la connexion audit pantographe (2), vers des dispositifs électriques de traction (4) du véhicule, **caractérisé en ce que** ledit équipement électrique (EE) comprend, disposés sur un support mécanique (40) :
- un appareil de disjonction (3) pour protéger lesdits dispositifs électriques de traction ;
- un dispositif de mesure (DM) comprenant au moins des moyens de mesure de l'intensité (33) et des moyens de mesure de la tension (34) du courant transmis depuis la caténaire (1) vers la ligne L de toiture , lesdits moyens de mesure de la tension (34) et de l'intensité (33) étant logés au sein d'un unique isolateur (25) ; et
- un calculateur (D) qui commande l'activation dudit appareil de disjonction (3),
et **en ce que en ce que** le dispositif de mesure (DM) est connecté d'une part directement au pantographe (2) par l'intermédiaire d'une unique connexion (52) et d'autre part à l'appareil de disjonction (3) par l'intermédiaire d'une unique connexion (51).

2. Equipement électrique (EE) selon la revendication 1, **caractérisé en ce que** le dispositif de mesure (DM) comprend un environnement haute tension confiné dans un premier évidement (28) ménagé dans l'isolateur (25) et un environnement basse tension confiné dans un second évidement (29) dudit isolateur (25).

3. Equipement électrique (EE) selon l'une quelconque des revendications 1 à 2,
**caractérisé en ce qu'**on dispose sur le support mécanique (40) au moins un des équipements de protection pris parmi :
- un sectionneur (36) de mise à la terre (37),
- un dispositif de protection (38) contre les surtensions,
- un disjoncteur alternatif (3).

4. Equipement électrique (EE) selon l'une des revendications 1 à 3, caractérisé qu'il comprend des raccordements électriques entre les équipements disposés sur le support (40).

5. Equipement électrique (EE) selon l'une des revendications 1 à 4, **caractérisé en ce que** le dispositif de mesure DM mesure le courant au point chaud.

6. Equipement électrique (EE) selon l'une quelconque des revendications 1 à 5,
**caractérisé en ce que** l'appareil de disjonction (3) est un disjoncteur monophasé.

## Patentansprüche

1. Elektrisches Gerät (EE) angeordnet auf dem Dach eines Eisenbahnfahrzeugs mit elektrischem Antrieb, wobei das Fahrzeug mit mindestens einem Stromabnehmer (2) und einer Dachleitung (L) ausgestattet ist, die den von einer Oberleitung (1) aufgenommen Strom ausgehend von der Verbindung mit dem Stromabnehmer (2) zu elektrischen Antriebsvorrichtungen (4) des Fahrzeugs überträgt, dadurch charakterisiert, dass das elektrische Gerät (EE) angeordnet auf einem mechanischen Träger (40) aufweist:
- eine Abtrennvorrichtung (3) zum Schützen der elektrischen Antriebsvorrichtungen;
- eine Messvorrichtung (DM) aufweisend mindestens Mittel zum Messen der Stärke (33) und Mittel zum Messen der Spannung (34) des von der Oberleitung (1) über die Dachleitung L übertragenen Stroms, wobei die Mittel zum Messen der Spannung (34) und der Stärke (33) im Inneren eines einzigen Isolators (25) angeordnet sind; und
- einen Rechner (D), der die Aktivierung der Abtrennvorrichtung (3) steuert,
und dadurch, dass die Messvorrichtung (DM) einerseits direkt mit dem Stromabnehmer (2) mittels einer einzigen Verbindung (52) und andererseits mit der Abtrennvorrichtung (3) mittels einer einzigen Verbindung (51) verbunden ist.

2. Elektrisches Gerät (EE) gemäß Anspruch 1, dadurch charakterisiert, dass die Messvorrichtung (DM) eine Hochspannungsumgebung aufweist, die in einer ersten Aussparung (28)untergebracht ist, die von dem Isolator (25) bereitgestellt wird, und eine Niederspannungsumgebung aufweist, die in einer zweiten Aussparung (29) des Isolators (25) untergebracht ist.

3. Elektrisches Gerät (EE) gemäß einem der Ansprüche 1 bis 2, dadurch charakterisiert, dass auf dem mechanischen Träger (40) mindestens eine Schutzvorrichtung der Folgenden angeordnet ist:
- ein Trennschalter (36) zum Erden (37),
- eine Überspannungsschutzvorrichtung (38),
- ein Wechselschalter (3).

4. Elektrisches Gerät (EE) gemäß einem der Ansprüche 1 bis 3, dadurch charakterisiert, dass es elektrische Verbindungen zwischen den auf dem Träger (40) angeordneten Geräten aufweist.

5. Elektrisches Gerät (EE) gemäß einem der Ansprüche 1 bis 4, dadurch charakterisiert, dass die Messvorrichtung DM den Strom am heißen Punkt misst.

6. Elektrisches Gerät (EE) gemäß einem der Ansprüche 1 bis 5, dadurch charakterisiert, dass die Abtrennvorrichtung (3) ein Einphasentrennschalter ist.

## Claims

1. Electrical equipment (EE) disposed on the roof of an electrically driven traction railway vehicle, said vehicle being equipped with at least one pantograph (2) and a roof wire (L) carrying the current collected from a catenary wire (1) from the connection to said pantograph (2) to electric traction devices (4) of the vehicle, **characterised in that** said electrical equipment (EE) comprises, disposed on a mechanical support (40):
- a circuit-breaking apparatus (3) for protecting said electric traction devices;
- a measuring device (DM) comprising at least means for measuring the intensity (33) and means for measuring the voltage (34) of the current transmitted from said catenary (1) to the roof wire L, said means for measuring the voltage (34) and intensity (33) being housed within a single isolator (25); and
- a computer (D) which controls activation of said circuit-breaking apparatus (3),
and **in that** said measuring device (DM) is connected to the pantograph (2) directly via a single connection (52) on the one hand and to the circuit-breaking apparatus (3) via a single connection (51) on the other hand.

2. Electrical equipment (EE) as claimed in claim 1, **characterised in that** the measuring device (DM) comprises a high voltage environment confined in a first recess (28) disposed in the isolator (25) and a low voltage environment confined in a second recess (29) of said isolator (25).

3. Electrical equipment (EE) as claimed in any one of claims 1 to 2, **characterised in that** at least one of the following pieces of protective equipment is disposed on the mechanical support (40):
- an isolating switch (36) for earthing (37),
- a device (38) for protecting against over-voltage,
- an AC circuit breaker (3).

4. Electrical equipment (EE) as claimed in one of claims 1 to 3, **characterised in that** it comprises electrical connections between the pieces of equipment disposed on the support (40).

5. Electrical equipment (EE) as claimed in one of claims 1 to 4, **characterised in that** the measuring device (DM) measures the current at a hot spot.

6. Electrical equipment (EE) as claimed in any one of claims 1 to 5, **characterised in that** the circuit-breaking apparatus (3) is a single-phase circuit breaker.
